# EUROPEAN PATENT APPLICATION

(11) **EP 2 003 700 A2**
(43) Date of publication of application: **17.12.2008**
(21) Application number: 07740862.3
(22) Date of filing: 03.04.2007
(51) Int. Cl.: H01L 31/04

(54) **PHOTOELECTRIC CONVERTER DEVICE AND PROCESS FOR PRODUCING THE SAME**

(30) Priority: 03.04.2006 JP 2006102162
(71) Applicant: Mitsubishi Heavy Industries, Ltd., Tokyo 108-8215 (JP)
(72) Inventor: GOYA, Saneyuki, Yokohama-shi Kanagawa 236-8515 (JP); SAKAI, Satoshi, Yokohama-shi Kanagawa 236-8515 (JP); SATAKE, Kouji, Yokohama-shi Kanagawa 236-8515 (JP)
(74) Representative: Bongiovanni, Simone
(86) International application number: PCT/JP2007/057426
(87) International publication number: WO 2007/114432

(57) **Abstract**

A photovoltaic device with improved cell properties having a photovoltaic layer comprising microcrystalline silicon-germanium, and a process for producing the device. A buffer layer comprising microcrystalline silicon or microcrystalline silicon-germanium, and having a specific Raman peak ratio is provided between a substrate-side impurity-doped layer and an i-layer comprising microcrystalline silicon-germanium.

## Description

### Technical Field

The present invention relates to a photovoltaic device having microcrystalline silicon-germanium as an i-layer of a photovoltaic layer, and a process for producing the same.

### Background Art

One known example of a photovoltaic device that converts the energy from sunlight into electrical energy is a thin-film silicon-based photovoltaic device in which the photovoltaic layer is formed by deposition using a plasma enhanced CVD method. One potential candidate for the photovoltaic layer film used in a thin-film silicon-based photovoltaic device is a microcrystalline silicon-germanium film. Because microcrystalline silicon-germanium films have a narrower gap than microcrystalline silicon and also exhibit excellent absorption properties, they hold considerable potential as photovoltaic materials capable of absorbing the long wavelength region of sunlight and thus improving the conversion efficiency by including these films in laminated structures with other photovoltaic materials such as amorphous silicon or microcrystalline silicon.

The largest portion of the photovoltaic layer is generally formed from an i-layer composed of an intrinsic semiconductor, and a structure is usually employed in which this i-layer is sandwiched between a thin p-layer formed from a semiconductor doped with a p-type impurity, and a thin n-layer formed from a semiconductor doped with an n-type impurity. In the case of photovoltaic devices having a photovoltaic layer of amorphous silicon-germanium or microcrystalline silicon-germanium, a technique has been disclosed in which a buffer layer formed from amorphous silicon is introduced between the p-layer and the i-layer, or between the n-layer and the i-layer, in order to improve the cell properties (for example, see patent citation 1).

Patent Citation 1: Publication of Japanese Patent No. 3,684,041 (paragraph [0021] and FIG. 1)

### Disclosure of Invention

However, in a photovoltaic device having a photovoltaic layer comprising microcrystalline silicon-germanium, there are cases where introducing a buffer layer of amorphous silicon between the p-layer and the i-layer, or between the n-layer and the i-layer, results in no improvement in the cell properties.

The present invention has been developed in light of the above circumstances, and has an object of providing a photovoltaic device with improved cell properties having a photovoltaic layer comprising microcrystalline silicon-germanium, as well as a process for producing the device.

The microcrystalline silicon-germanium used in the photovoltaic layer differs from amorphous silicon-germanium, and the crystallinity has an effect on the cell properties. In the technique described above within the "Background Art", in which a buffer layer was introduced for the photovoltaic layer containing amorphous silicon-germanium or microcrystalline silicon-germanium, the electrical properties of the resulting device structure were considered, but until now, no technique has been proposed that also considers the crystal growth of the microcrystalline silicon-germanium. The inventors of the present invention focused their attention on the film quality of the buffer layer, not only in terms of its effect on the electrical properties of the device structure, but also in terms of its the role as a base layer during crystal growth of the microcrystalline silicon-germanium of the i-layer, and they were therefore able to complete the present invention.

In other words, the photovoltaic device of the present invention is a photovoltaic device having a substrate and a photovoltaic layer provided on top of the substrate, the photovoltaic layer including a p-layer comprising a semiconductor doped with a p-type impurity, an n-layer comprising a semiconductor doped with an n-type impurity, and an i-layer comprising mainly microcrystalline silicon-germanium that is provided between the p-layer and the n-layer, wherein a buffer layer comprising mainly microcrystalline silicon or microcrystalline silicon-germanium is disposed between the substrate-side impurity-doped layer, which is the layer among the p-layer and the n-layer positioned closer to the substrate, and the above i-layer, and the Raman peak ratio Ic(1)/Ia(1) (480 cm⁻¹) for the buffer layer, which represents the ratio within a Raman spectroscopic measurement spectrum of the peak intensity Ic(1) of the crystalline phase relative to the peak intensity Ia(1) of the amorphous phase, is not less than 0.8. A ratio of 0.8 or greater means that the buffer layer comprises an essentially crystalline layer. The p-layer and n-layer may be microcrystalline silicon, microcrystalline SiGe or microcrystalline SiC.
In this photovoltaic device, because the buffer layer provided on the substrate-side of the i-layer has a high degree of crystallinity, the film quality of the microcrystalline silicon-germanium within the i-layer is improved, thereby improving the cell properties.

Alternatively, the photovoltaic device of the present invention may be a photovoltaic device having a substrate and a photovoltaic layer provided on top of the substrate, the photovoltaic layer including a p-layer comprising a semiconductor doped with a p-type impurity, an n-layer comprising a semiconductor doped with an n-type impurity, and an i-layer comprising mainly microcrystalline silicon-germanium that is provided between the p-layer and the n-layer, wherein a Raman peak ratio Ic(2)/Ia(2) for the substrate-side impurity-doped layer, which is the layer among the p-layer and the n-layer that is positioned closer to the substrate, is not less than 2, in which the Raman peak ratio Ic(2)/Ia(2) represents the ratio within a Raman spectroscopic measurement spectrum of a peak intensity Ic(2) of a crystalline phase relative to a peak intensity Ia(2) of an amorphous phase.
In this photovoltaic device, because the substrate-side impurity-doped layer has a high degree of crystallinity, the film quality of the microcrystalline silicon-germanium within the i-layer is improved, thereby improving the cell properties.

Providing a buffer layer comprising mainly microcrystalline silicon or microcrystalline silicon-germanium between the substrate-side impurity-doped layer and the i-layer is preferred, as it enables the degree of improvement in the cell properties to be further enhanced.

In either of the photovoltaic devices described above, if the electrical properties are considered, then the germanium concentration within the buffer layer is preferably lower than the germanium concentration within the i-layer.

A process for producing a photovoltaic device according to the present invention is a process comprising the formation of a photovoltaic layer on top of a substrate, the formation of the photovoltaic layer comprising the steps of: forming a p-layer comprising a semiconductor doped with a p-type impurity, an i-layer comprising mainly microcrystalline silicon-germanium, and an n-layer comprising a semiconductor doped with an n-type impurity, either in that sequence or in a reverse sequence, and further comprising a step of forming a buffer layer comprising mainly microcrystalline silicon or microcrystalline silicon-germanium, which is performed between the step of forming the substrate-side impurity-doped layer, which is the layer among the p-layer and the n-layer positioned closer to the substrate, and the step of forming the i-layer, wherein the Raman peak ratio Ic(1)/Ia(1) for the buffer layer, which represents the ratio within a Raman spectroscopic measurement spectrum of the peak intensity Ic(1) of the crystalline phase relative to the peak intensity Ia(1) (480 cm⁻¹) of the amorphous phase, is not less than 0.8. The p-layer and n-layer may be microcrystalline silicon, microcrystalline SiGe or microcrystalline SiC.
Furthermore, layers comprising mainly microcrystalline silicon or microcrystalline silicon-germanium may be formed in advance under a variety of conditions in order to enable setting of the conditions, and the conditions that result in a Raman peak ratio Ic(1)/Ia(1) for this layer, namely a ratio within the Raman spectroscopic measurement spectrum of the peak intensity Ic(1) of the crystalline phase relative to the peak intensity Ia(1) of the amorphous phase, of not less than 0.8 may then be selected and used as the basis for formation of the buffer layer.
According to this process for producing a photovoltaic device, because the crystallinity of the buffer layer provided on the substrate-side of the i-layer is enhanced, the film quality of the microcrystalline silicon-germanium within the i-layer improves, enabling production of a photovoltaic device with improved cell properties.

Alternatively, the process for producing a photovoltaic device according to the present invention may be a process comprising the formation of a photovoltaic layer on top of a substrate, the formation of the photovoltaic layer comprising the steps of: forming a p-layer comprising a semiconductor doped with a p-type impurity, an i-layer comprising mainly microcrystalline silicon-germanium, and an n-layer comprising a semiconductor doped with an n-type impurity, either in that sequence or in a reverse sequence, wherein in the step of forming the substrate-side impurity-doped layer, which is the layer among the p-layer and the n-layer positioned closer to the substrate, the Raman peak ratio Ic(2)/Ia(2) of the substrate-side impurity-doped layer, which represents the ratio within a Raman spectroscopic measurement spectrum of the peak intensity Ic(2) of the crystalline phase relative to the peak intensity Ia(2) (480 cm⁻¹) of the amorphous phase, is not less than 2.
Furthermore, impurity-doped layers may be formed in advance under a variety of conditions in order to enable setting of the conditions, and the conditions that result in a Raman peak ratio Ic(2)/Ia(2) for this layer, namely a ratio within the Raman spectroscopic measurement spectrum of the peak intensity Ic(2) of the crystalline phase relative to the peak intensity Ia(2) of the amorphous phase, of not less than 2 may then be selected and used as the basis for formation of the impurity-doped layer of the photovoltaic device.
According to this process for producing a photovoltaic device, because the crystallinity of the substrate-side impurity-doped layer is enhanced, the film quality of the microcrystalline silicon-germanium within the i-layer improves, enabling production of a photovoltaic device with improved cell properties.

Providing a step of forming a buffer layer comprising mainly microcrystalline silicon or microcrystalline silicon-germanium between the step of forming the substrate-side impurity-doped layer and the step of forming the i-layer is preferred, as it enables the degree of improvement in the cell properties to be further enhanced.

In either of the processes for producing a photovoltaic device described above, if the electrical properties of the produced photovoltaic device are taken into consideration, then the germanium concentration within the buffer layer is preferably lower than the germanium concentration within the i-layer.

The present invention is able to provide a photovoltaic device with improved cell properties having a photovoltaic layer comprising microcrystalline silicon-germanium, as well as a process for producing the device.

### Brief Description of Drawings

[FIG. 1] A schematic partial sectional view showing a photovoltaic device according to a first embodiment.
[FIG. 2] An enlarged sectional view of a photovoltaic layer within the photovoltaic device according to the first embodiment.
[FIG. 3] A schematic view showing an example of a plasma enhanced CVD apparatus.
[FIG. 4] A graph showing the relationship between the crystallinity of the first buffer layer and the short-circuit current density.
[FIG. 5] A graph showing the relationship between the crystallinity of the first buffer layer and the open-circuit voltage.
[FIG. 6] A graph showing the relationship between the crystallinity of the first buffer layer and the fill factor.
[FIG. 7] A graph showing the relationship between the crystallinity of the first buffer layer and the cell efficiency.
[FIG. 8] A schematic partial sectional view showing a photovoltaic device according to a second embodiment.
[FIG. 9] A schematic partial sectional view showing a photovoltaic device according to a third embodiment.

### Explanation of Reference:

- 1:: Substrate
- 2:: First transparent electrode
- 3:: Photovoltaic layer
- 4:: p-layer
- 5:: i-layer
- 51:: First buffer layer
- 52:: Second buffer layer
- 6:: n-layer
- 9:: Second transparent electrode
- 10:: Back electrode
- 11:: Vacuum chamber
- 12:: First electrode
- 13:: Second electrode
- 14:: Raw material gas supply unit
- 15:: Gas flow rate controller
- 16:: Gas storage unit
- 17:: High frequency power source
- 18:: Gas supply unit
- 19:: Raw material gas
- 20:: Plasma enhanced CVD apparatus
- 31:: First photovoltaic layer (top cell)
- 33:: Second photovoltaic layer (bottom cell)
- 41:: First photovoltaic layer (top cell)
- 42:: Second photovoltaic layer (middle cell)
- 43:: Third photovoltaic layer (bottom cell)

### Best Mode for Carrying Out the Invention

Embodiments of the photovoltaic device and the process for producing a photovoltaic device according to the present invention are described below with reference to the drawings.

### (First Embodiment)

This embodiment provides a description of a so-called single type photovoltaic layer, having a p-layer composed of a semiconductor doped with a p-type impurity and an n-layer composed of a semiconductor doped with an n-type impurity formed on the top and bottom of an i-layer composed of an intrinsic semiconductor. In this embodiment, the description focuses on a photovoltaic device with a substrate-side illuminated PIN structure, but the technology could be expected to yield similar effects in a NIP structure or film-side illuminated photovoltaic device.

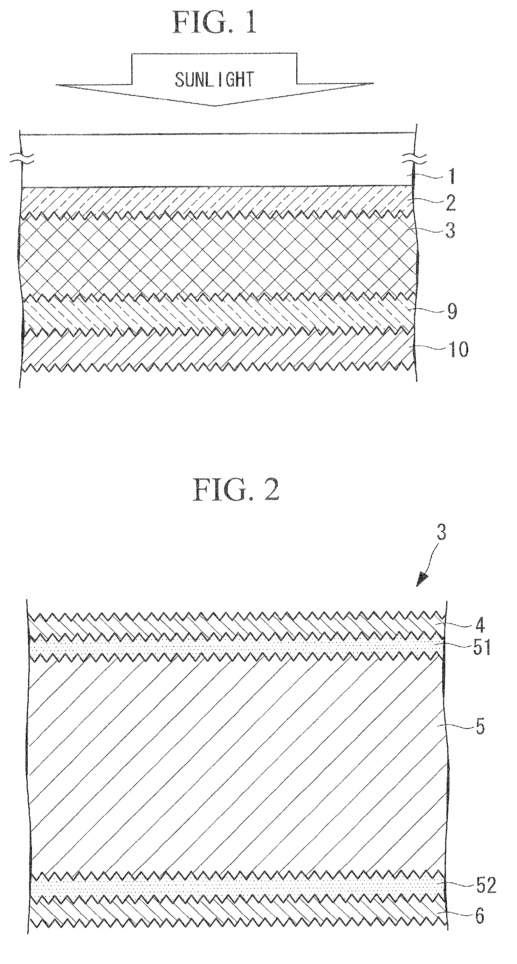

FIG. 1 is a schematic sectional view showing a photovoltaic device according to the first embodiment. This photovoltaic device comprises a substrate 1, a first transparent electrode 2, a photovoltaic layer 3, a second transparent electrode 9, and a back electrode 10.

The substrate 1 is a transparent, electrically insulating substrate onto which the photovoltaic layer 3 and the various electrodes are deposited. The substrate 1 is exemplified by a thin sheet of white sheet glass. The first transparent electrode 2 is the electrode on the sunlight-incident side of the photovoltaic device, and is exemplified by a transparent conductive oxide material such as tin oxide (SnO₂) or zinc oxide (ZnO).

The photovoltaic layer 3 is a layer that converts light into electricity. FIG. 2 shows an enlarged sectional view of the photovoltaic layer 3. The photovoltaic layer 3 comprises a p-layer 4, an i-layer 5, and an n-layer 6. The p-layer 4 is a semiconductor layer that has been doped with a p-type impurity. The p-layer 4 is exemplified by a p-type microcrystalline silicon. The i-layer 5 is a semiconductor layer that has not been intentionally doped with an impurity. The i-layer 5 comprises microcrystalline silicon-germanium. The n-layer 6 is a semiconductor layer that has been doped with an n-type impurity. The n-layer 6 is exemplified by an n-type microcrystalline silicon.

A first buffer layer 51 is formed between the p-layer 4 and the i-layer 5. The first buffer layer 51 is a buffer layer comprising mainly microcrystalline silicon or microcrystalline silicon-germanium, and the Raman peak ratio Ic(1)/Ia(1) for the buffer layer, which represents the ratio within a Raman spectroscopic measurement spectrum of the peak intensity Ic(1) of the crystalline phase relative to the peak intensity Ia(1) (480 cm⁻¹) of the amorphous phase, is specified as being not less than 0.8. Although a peak shift occurs in the case of microcrystalline SiGe, the peak intensity attributable to a crystalline Si layer can be used as Ic, and the intensity at 480 cm⁻¹ can be used as Ia.
The Raman peak ratio is an indicator of the crystallization ratio, and is measured as follows. First, a measuring light is irradiated onto the film surface of the first buffer layer 51. Monochromatic laser light is used as the measuring light, and the use of frequency-doubled YAG laser light (wavelength: 532 nm) is ideal. When the measuring light is irradiated from the film surface side of the first buffer layer, Raman scattering is observed. In the Raman spectrum obtained by spectroscopic analysis of the emitted Raman scattered light, a Raman peak ratio Ic(1)/Ia(1) that represents the ratio of the peak intensity Ic(1) of the crystalline phase relative to the peak intensity Ia(1) of the amorphous phase can be determined. Here, the "peak intensity of the amorphous phase" typically refers to the peak intensity near a frequency of 480 cm⁻¹, whereas the "peak intensity of the crystalline phase" typically refers to the peak intensity near a frequency of 520 cm⁻¹.

In those cases where microcrystalline silicon-germanium is employed as the first buffer layer 51, if the electrical properties are considered, then the germanium concentration within the first buffer layer is preferably lower than the germanium concentration within the i-layer 5.

Furthermore, in order to improve th electrical properties of the device structure, a second buffer layer 52 may be provided between the i-layer 5 and the n-layer 6. This second buffer layer 52 differs from the first buffer layer 51, and there are no particular restrictions regarding its crystallinity. Examples of materials that can be used as the second buffer layer 52 include microcrystalline silicon, microcrystalline silicon-germanium, amorphous silicon and amorphous silicon-germanium. By providing this type of second buffer layer 52, an improvement in the electric field strength can be expected as a result of an optimization of the band structure.

Furthermore, another layer may be inserted between the first transparent electrode 2 and the photovoltaic layer 3. Examples of such layers include a layer that improves the crystallinity of the upper layer, and a layer that prevents the diffusion of impurities from other layers.

The second transparent electrode 9 and the back electrode 10 represent the electrodes on the back side of the photovoltaic device. The second transparent electrode 9 is exemplified by transparent conductive oxide materials such as ZnO or indium tin oxide (ITO). The back electrode 10 is exemplified by high reflectance metals such as silver (Ag) and aluminum (A1). Another layer (such as a layer that improves the reflectance or light scattering of the second transparent electrode 9) may be inserted between the second transparent electrode 9 and the photovoltaic layer 3.

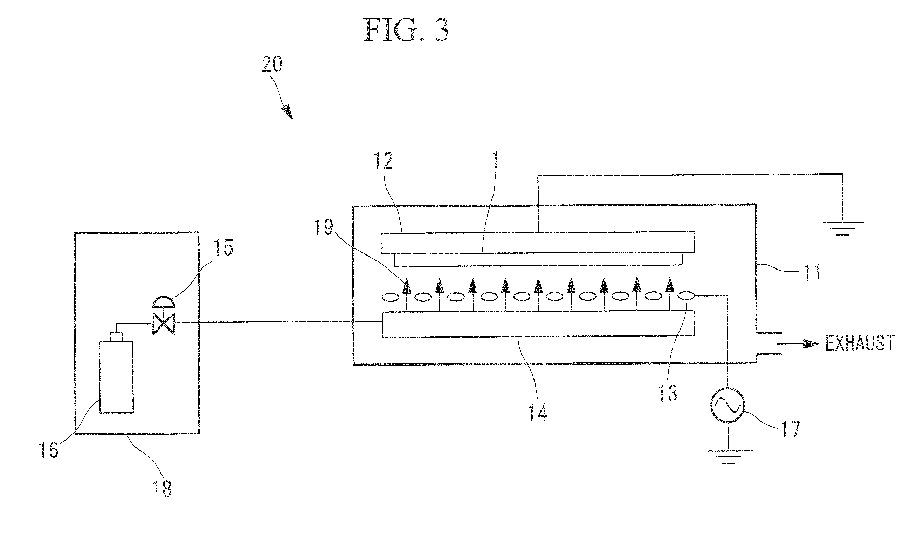

Next is a description of a process for producing the photovoltaic device according to the first embodiment. FIG. 3 is a schematic view showing an example of a plasma enhanced CVD apparatus used for producing the photovoltaic device of this embodiment. The plasma enhanced CVD apparatus 20 comprises a vacuum chamber 11, a high frequency power source 17, a gas supply unit 18, and although not shown in the figure, a turbomolecular pump and rotary pump for vacuum evacuation of the vacuum chamber, and a dry pump (not shown) for exhausting the raw material gases. Moreover, although not shown in the figure, a different plasma enhanced CVD apparatus is provided for film deposition of each of the p-, i- and n-layers, and these plasma enhanced CVD apparatuses are arranged so that the substrate can be transported under vacuum from one apparatus to the next via a transport chamber.

The ultra high frequency power source 17 supplies high frequency electrical power with desired properties (for example, a plasma excitation frequency of 60 to 120 MHz) to the discharge electrode (described below) inside the vacuum chamber 11. The gas supply unit 18 supplies a raw material gas 19 at a predetermined flow rate or flow rate ratio from a gas storage unit 16 to the vacuum chamber 11 via a gas flow rate controller 15. The gas storage unit 16 is exemplified by a plurality of gas cylinders containing different gases. The gas flow rate controller 15 is exemplified by mass flow meters provided for each of the plurality of gas cylinders. In the vacuum chamber 11, the supplied high frequency electrical power and the supplied gas or plurality of gases enable films that form each of the layers of the photovoltaic device to be deposited on top of the substrate 1.

The vacuum chamber 11 comprises a first electrode 12, a second electrode 13, and a raw material gas supply unit 14. The first electrode 12 incorporates a heater function for heating the substrate, and also supports and grounds the substrate 1. The second electrode 13 is supplied with the desired level of electrical power from the high frequency power source 17, and generates a plasma of the supplied raw material gas 19 between the second electrode 13 and the first electrode 12. The second electrode 13 is separated from the substrate 1 by a predetermined gap length dg, and opposes the first electrode 12. In this embodiment, parallel plate electrodes are used, but there are no particular restrictions on the electrode shape. The raw material gas supply unit 14 introduces the raw material gas 19 into the space where the plasma is formed (the space between the first electrode 12 and the second electrode 13) via the gaps within the second electrode 13. The second electrode 13 and the raw material gas supply unit 14 may be integrated, so that one of the components incorporates the function of the other.

A process for producing the photovoltaic device is described below. The production conditions described below merely represent a single example, and the present invention is not limited to these conditions.
(1) First, a base material is prepared by using a heated CVD method to form a film of SnO₂ as the first transparent electrode 2 on the surface of a white sheet glass substrate as the substrate 1, and this base material is then washed with pure water or alcohol. A film that is required for ensuring favorable growth of the SnO₂, or a refractive index adjustment film that lowers the reflectance may be inserted between the white sheet glass and the SnO₂.

(2) Next, the substrate 1 is installed inside a plasma enhanced CVD apparatus used for p-layer deposition, and a p-type microcrystalline silicone film that functions as the p-layer 4 of the photovoltaic layer 3 is deposited by plasma enhanced CVD on the surface of the first transparent electrode 2 formed on top of the substrate 1. The deposition conditions involve vacuum evacuation of the chamber 11 to a pressure of not more than 10⁻⁴ Pa, and then heating of the substrate 1 to 150°C. The raw material gases SiH₄, H₂, and B₂H₆, which acts as the p-type impurity gas, are then introduced into the vacuum chamber 11 at flow rates of 3, 300 and 0.02 sccm respectively, and the pressure is controlled at 67 Pa. The gap length dg is 25 mm. By subsequently supplying high frequency electrical power of 100 MHz - 5 kW/m² from the high frequency power source 17 to the second electrode 13, a plasma is generated between the second electrode 13 and the substrate 1, thereby depositing a p-type microcrystalline silicon layer of 20 nm as the p-layer 4 on top of the first transparent electrode 2.

(3) Subsequently, an i-type microcrystalline silicon film that functions as the first buffer layer 51 is deposited by plasma enhanced CVD on top of the p-layer 4. Deposition of the first buffer layer 51 may be performed in either the p-layer deposition chamber or the i-layer deposition chamber, or may, of course, also be performed in a dedicated buffer layer deposition chamber. The deposition conditions involve vacuum evacuation of the chamber 11 to a pressure of not more than 10⁻⁴ Pa, and then heating of the substrate 1 to 200°C. The raw material gases SiH₄ and H₂ are then introduced into the vacuum chamber 11 at flow rates of 0.5 SLM/m² and 15 SLM/m² respectively, and the pressure is controlled at 266 Pa. The gap length dg is 5 mm. By subsequently supplying high frequency electrical power of 100 MHz - 3 kW/m² from the high frequency power source 17 to the second electrode 13, a plasma is generated between the second electrode 13 and the substrate 1, thereby depositing a microcrystalline silicon layer as the first buffer layer 51 on top of the p-layer 4. If GeH₄ is introduced as a raw material gas during this process, then a first buffer layer 51 comprising microcrystalline silicon-germanium can be deposited. Furthermore, by altering the flow rates of the SiH₄ and GeH₄ over time, a first buffer layer 51 can be formed with a profile in which the Ge concentration increases from the p-layer 4 through to the i-layer 5.
The crystallinity of the first buffer layer can be controlled by adjusting the ratio H₂/SiH₄ or the ratio H₂/(SiH₄+GeH₄). Furthermore, the crystallinity also changes with variations in the electrical power level, the pressure and the gap length, and the crystallinity may also be controlled by selecting suitable values for the ratio H₂/SiH₄ or the ratio H₂/(SiH₄+GeH₄) at the conditions chosen. The conditions required for controlling the crystallinity of the first buffer layer can be set by first depositing layers comprising mainly microcrystalline silicon or microcrystalline silicon-germanium (for example, with a film thickness of approximately 500 nm) as condition-setting samples under a variety of conditions, and then selecting the deposition conditions that yield the desired crystallinity. Deposition can then be performed for the actual photovoltaic device based on these selected crystallinity control conditions.

(4) Subsequently, a microcrystalline silicon-germanium film that functions as the i-layer 5 is deposited by plasma enhanced CVD on top of the first buffer layer 51. The deposition conditions involve vacuum evacuation of the chamber 11 to a pressure of not more than 10⁻⁴ Pa, and then heating of the substrate 1 to 200°C. The raw material gases are then introduced into the vacuum chamber 11, and the pressure is controlled at 267 Pa. A raw material gas for silicon and a raw material gas for germanium are used as the raw material gases. The raw material gas for silicon comprises at least one of SiH₄, Si₂H₆ and SiF₄. The raw material gas for germanium comprises at least one of GeH₄ and GeF₄. The gap length dg is 5 mm. By subsequently supplying high frequency electrical power of 100 MHz - 3 kW/m² from the high frequency power source 17 to the second electrode 13, a plasma is generated between the second electrode 13 and the substrate 1, thereby depositing a microcrystalline silicon-germanium layer of 1000nm as the i-layer 5 on top of the first buffer layer 51.

(5) If necessary, a second buffer layer 52 may be deposited by plasma enhanced CVD on top of the i-layer 5. Deposition of the second buffer layer 52 may be performed in either the n-layer deposition chamber or the i-layer deposition chamber, or may, of course, also be performed in a dedicated buffer layer deposition chamber. The second buffer layer 52 may be deposited, for example, using the same method as that described for the first buffer layer 51.
Namely, an i-type microcrystalline silicon film that functions as the second buffer layer 52 may be deposited by plasma enhanced CVD on top of the i-layer 5. Deposition of the second buffer layer 52 may be performed in either the i-layer deposition chamber or the n-layer deposition chamber, or may, of course, also be performed in a dedicated buffer layer deposition chamber. The deposition conditions involve vacuum evacuation of the chamber 11 to a pressure of not more than 10⁻⁴ Pa, and then heating of the substrate 1 to 200°C. The raw material gases SiH₄ and H₂ are then introduced into the vacuum chamber 11 at flow rates of 0.8 SLM/m² and 15 SLM/m² respectively, and the pressure is controlled at 266 Pa. The gap length dg is 5 mm. By subsequently supplying high frequency electrical power of 100 MHz - 3 kW/m² from the high frequency power source 17 to the second electrode 13, a plasma is generated between the second electrode 13 and the substrate 1, thereby depositing a microcrystalline silicon layer as the second buffer layer 52 on top of the i-layer 5. If GeH₄ is introduced as a raw material gas during this process, then a second buffer layer 52 comprising microcrystalline silicon-germanium can be deposited. Furthermore, by altering the flow rates of the SiH₄ and GeH₄ over time, a second buffer layer 52 can be formed with a profile in which the Ge concentration increases from the p-layer 4 through to the i-layer 5.
The crystallinity of the second buffer layer can be controlled by adjusting the ratio H₂/SiH₄ or the ratio H₂/ (SiH₄+GeH₄).

(6) Next, an n-type microcrystalline silicone film that functions as the n-layer 6 is deposited by plasma enhanced CVD on the surface of the second buffer layer 52 or the i-layer 5. The deposition conditions involve vacuum evacuation of the chamber 11 to a pressure of not more than 10⁻⁴ Pa, and then heating of the substrate 1 to 170°C. The raw material gases SiH₄, H₂, and PH₃, which acts as the n-type impurity gas, are then introduced into the vacuum chamber 11 at flow rates of 3, 300 and 0.1 sccm respectively, and the pressure is controlled at 93 Pa. The gap length dg is 25 mm. By subsequently supplying high frequency electrical power of 60 MHz - 1.5 kW/m² from the high frequency power source 17 to the second electrode 13, a plasma is generated between the second electrode 13 and the substrate 1, thereby depositing an n-type microcrystalline silicon layer of 30 nm as the n-layer 6 on top of the second buffer layer 52.
(7) Subsequently, sputtering is used to deposit a ZnO film of 80 nm as the second transparent electrode 9 on top of the n-layer 6, and then an Ag film of 300 nm as the back electrode 10 on top of the second transparent electrode 9. The deposition conditions may employ conventional conditions.

In this manner, a photovoltaic device is formed that includes microcrystalline silicon-germanium as the i-layer of the photovoltaic layer 3.

### (Examples and Comparative Examples)

The photovoltaic device of the first embodiment shown in FIG. 1 and FIG. 2 was fabricated under two different sets of deposition conditions, and the resulting devices were termed example 1 and example 2 respectively. The first buffer layer was a microcrystalline silicon layer in both the example 1 and the example 2. In the photovoltaic devices of the example 1 and the example 2, the Raman peak ratio Ic(1)/Ia(1) that indicates the crystallinity of the first buffer layer 51 was 3.7 and 9.5 respectively. The Raman peak ratio that indicates the crystallinity of the buffer layer was calculated as the ratio between the intensity Ic of the peak attributable to the crystalline phase (approximately 520 cm⁻¹) and the intensity Ia of the peak attributable to the amorphous phase (480 cm⁻¹) within the Raman spectrum for a film of 500 nm deposited on a glass substrate. The Raman spectrum was measured using a microscopic Raman spectrometer, using frequency-doubled YAG laser light of 532 nm as the light source.
Furthermore, a photovoltaic device that contained no first buffer layer 51, and a photovoltaic device in which the first buffer layer 51 was replaced with an amorphous silicon layer were produced as a comparative example 1 and a comparative example 2 respectively.

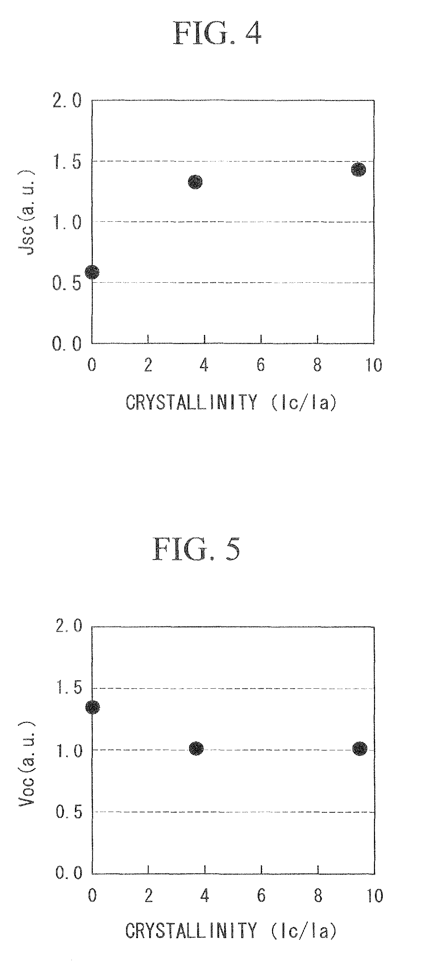

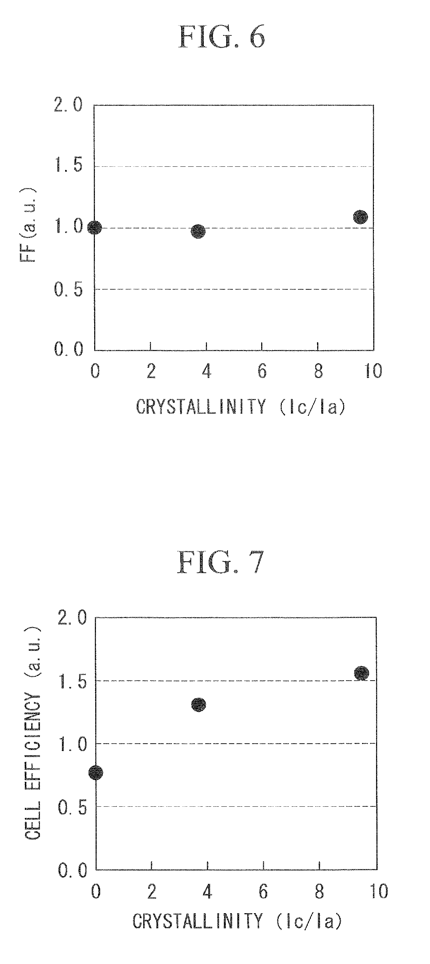

The cell properties (the short-circuit current density Jsc, the open-circuit voltage Voc, the fill factor FF, and the cell efficiency) were measured for the photovoltaic devices of the examples 1 and 2, and the comparative examples 1 and 2. FIG. 4 through FIG. 7 are graphs showing the relationships between the crystallinity of the first buffer layer and the cell properties, wherein FIG. 4 shows the short-circuit current density Jsc, FIG. 5 shows the open-circuit voltage Voc, FIG. 6 shows the fill factor FF, and FIG. 7 shows the cell efficiency. In each graph, the value for the particular cell property is expressed as a relative value, wherein the value for the comparative example 1 (which contains no first buffer layer) is deemed to be 1. The results are omitted for the comparative example 1.

The cell efficiency of the photovoltaic device of the comparative example 2, which contained an amorphous silicon layer (crystallinity: 0) as the first buffer layer 51, was 0.77, which represents a reduction of more than 20% from the value for the photovoltaic device of the comparative example 1 that contained no first buffer layer 51. Furthermore, compared with the photovoltaic device of the comparative example 1, the photovoltaic device of the comparative example 2 exhibited an increased open-circuit voltage Voc, and a reduced short-circuit current density Jsc. In the photovoltaic device of the comparative example 2, it is thought that the amorphous silicon layer used as the first buffer layer 51 has an effect on the crystallinity of the microcrystalline silicon-germanium that constitutes the i-layer 5, causing a dramatic reduction in the crystallinity of the i-layer 5.
Accordingly, it is evident that in photovoltaic devices comprising microcrystalline silicon-germanium as the i-layer 5, the introduction of a buffer layer does not necessarily result in improved cell properties.

In contrast, in the photovoltaic devices of the example 1 and example 2, which contain a layer of microcrystalline silicon of improved crystallinity as the first buffer layer 51, the short-circuit current density Jsc improves markedly, and the cell efficiency compared with that of the comparative example 1, increases approximately 30% for the example 1 and approximately 55% for the example 2. These observations are the effects obtained as a result of the first buffer layer 51 increasing the internal electric field strength by optimizing the band structure at the p/i interface, and improving the crystallinity and film quality of the microcrystalline silicon-germanium of the i-layer 5.
In other words, using a microcrystalline silicon with a high degree of crystallinity as the first buffer layer 51 also improves the film quality of the microcrystalline silicon-germanium of the i-layer 5. As a result, the cell efficiency of the photovoltaic device improves.

Moreover, similar effects are achieved when microcrystalline silicon-germanium is used instead of microcrystalline silicon as the first buffer layer 51. In such cases, the germanium concentration within the first buffer layer 51 is set to a lower value than the germanium concentration in the microcrystalline silicon-germanium of the i-layer 5.

### (Second Embodiment)

This embodiment provides a description of a so-called tandem type photovoltaic layer having two photovoltaic layers, wherein each photovoltaic layer comprises a p-layer composed of a semiconductor doped with a p-type impurity and an n-layer composed of a semiconductor doped with an n-type impurity formed on the top and bottom of an i-layer composed of an intrinsic semiconductor. In this embodiment, the description focuses on a photovoltaic device with a substrate-side illuminated PIN structure, but the technology could be expected to yield similar effects in a NIP structure or film-side illuminated photovoltaic device.

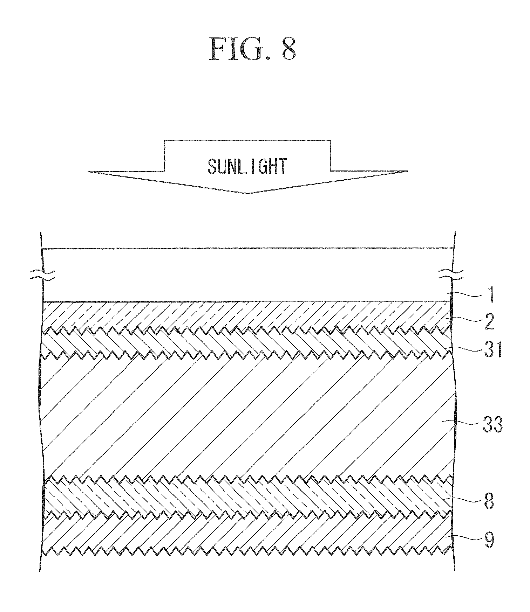

FIG. 8 is a schematic partial sectional view showing a photovoltaic device according to the second embodiment. This photovoltaic device comprises a substrate 1, a first transparent electrode 2, a first photovoltaic layer (a top cell) 31, a second photovoltaic layer (a bottom cell) 33, a second transparent electrode 9, and a back electrode 10.
The substrate 1, the first transparent electrode 2, the second transparent electrode 9 and the back electrode 10 are the same as those described for the first embodiment, and therefore their descriptions are omitted here. Furthermore, the second photovoltaic layer (the bottom cell) 33 has the same configuration as the photovoltaic layer 3 of the first embodiment, and therefore its description is also omitted.
The first photovoltaic layer (the top cell) 31 may employ amorphous silicon, microcrystalline silicon, amorphous silicon-germanium or microcrystalline silicon carbide or the like.

In the tandem type photovoltaic device of this embodiment, because the second photovoltaic layer 33 has the same configuration as the photovoltaic layer 3 of the first embodiment, microcrystalline silicon with a high degree of crystallinity is used as the first buffer layer within the second photovoltaic layer 33, thereby improving the film quality of the microcrystalline silicon-germanium of the i-layer. As a result, the cell efficiency of the photovoltaic device also improves.

### (Third Embodiment)

This embodiment provides a description of a so-called triple type photovoltaic layer having three photovoltaic layers, wherein each photovoltaic layer comprises a p-layer composed of a semiconductor doped with a p-type impurity and an n-layer composed of a semiconductor doped with an n-type impurity formed on the top and bottom of an i-layer composed of an intrinsic semiconductor. In this embodiment, the description focuses on a photovoltaic device with a substrate-side illuminated PIN structure, but the technology could be expected to yield similar effects in a NIP structure or film-side illuminated photovoltaic device.

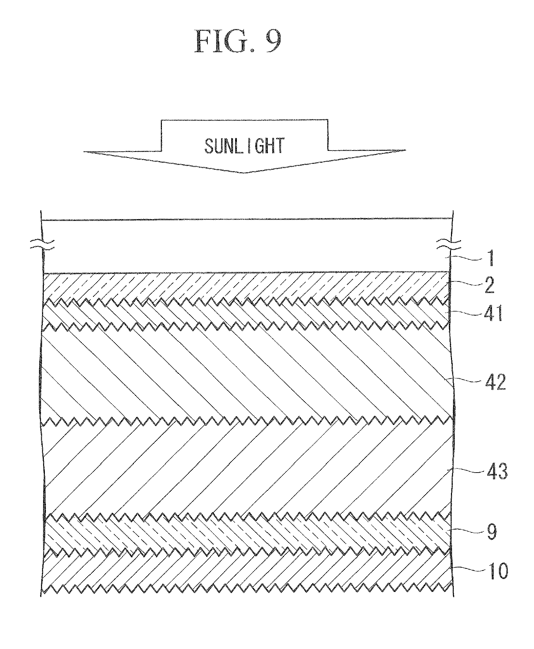

FIG. 9 is a schematic partial sectional view showing a photovoltaic device according to the third embodiment. This photovoltaic device comprises a substrate 1, a first transparent electrode 2, a first photovoltaic layer (a top cell) 41, a second photovoltaic layer (a middle cell) 42, a third photovoltaic layer (a bottom cell) 43, a second transparent electrode 9, and a back electrode 10.
The substrate 1, the first transparent electrode 2, the second transparent electrode 9 and the back electrode 10 are the same as those described for the first embodiment, and therefore their descriptions are omitted here. Furthermore, the third photovoltaic layer (the bottom cell) 43 has the same configuration as the photovoltaic layer 3 of the first embodiment, and therefore its description is also omitted.

Amorphous silicon is employed for the first photovoltaic layer (the top cell) 41, and microcrystalline silicon is employed for the second photovoltaic layer. Examples of other configurations that may be employed for the combination of the first photovoltaic layer / second photovoltaic layer/ third photovoltaic layer include, besides the combination described above, amorphous silicon / amorphous silicon / microcrystalline silicon-germanium, amorphous silicon / amorphous silicon-germanium /microcrystalline silicon-germanium, and microcrystalline silicon carbide / amorphous silicon / microcrystalline silicon-germanium.

In the triple type photovoltaic device of this embodiment, because the third photovoltaic layer 43 has the same configuration as the photovoltaic layer 3 of the first embodiment, microcrystalline silicon with a high degree of crystallinity is used as the first buffer layer within the third photovoltaic layer 43, thereby improving the film quality of the microcrystalline silicon-germanium of the i-layer. As a result, the cell efficiency of the photovoltaic device also improves.

### (Fourth Embodiment)

In the first embodiment, the cell efficiency of the photovoltaic layer comprising microcrystalline silicon-germanium as the i-layer was improved by improving the crystallinity of the first buffer layer 51, but in this embodiment, the crystallinity of the p-layer 4 is improved without providing a first buffer layer 51. The p-layer 4 comprises mainly microcrystalline silicon or microcrystalline silicon-germanium, and has a Raman peak ratio Ic(2)/Ia(2), which represents the ratio within a Raman spectroscopic measurement spectrum of the peak intensity Ic(2) of the crystalline phase relative to the peak intensity Ia(2) of the amorphous phase, that is specified as being not less than 2, and preferably not less than 4. The method used for measuring the Raman peak ratio for the p-layer 4 is the same as that used for measuring the first buffer layer 51 in the first embodiment, and a description of the method is therefore omitted here.
By improving the crystallinity of the p-layer 4, the crystallinity and film quality of the i-layer 5 composed of microcrystalline silicon-germanium also improves, yielding improved cell properties.

### (Modified Example of Fourth Embodiment)

In the fourth embodiment, providing a buffer layer between the p-layer 4 of improved crystallinity and the i-layer 5 composed of microcrystalline silicon-germanium is preferred, as it enables the degree of improvement in the cell properties to be further enhanced. Microcrystalline silicon or microcrystalline silicon-germanium can be used as this buffer layer. In those cases where microcrystalline silicon-germanium is employed as the buffer layer, if the electrical properties are considered, then the germanium concentration within the first buffer layer is preferably lower than the germanium concentration within the i-layer 5.

## Claims

1. A photovoltaic device having a substrate and a photovoltaic layer provided on top of the substrate,
the photovoltaic layer including a p-layer comprising a semiconductor doped with a p-type impurity, an n-layer comprising a semiconductor doped with an n-type impurity, and an i-layer comprising mainly microcrystalline silicon-germanium that is provided between the p-layer and the n-layer, wherein
a buffer layer comprising mainly microcrystalline silicon or microcrystalline silicon-germanium is disposed between a substrate-side impurity-doped layer, which is a layer among the p-layer and the n-layer that is positioned closer to the substrate, and the i-layer, and
a Raman peak ratio Ic(1)/Ia(1) for the buffer layer, which represents a ratio within a Raman spectroscopic measurement spectrum of a peak intensity Ic(1) of a crystalline phase relative to a peak intensity Ia(1) of an amorphous phase, is not less than 0.8.

2. A photovoltaic device having a substrate and a photovoltaic layer provided on top of the substrate,
the photovoltaic layer including a p-layer comprising a semiconductor doped with a p-type impurity, an n-layer comprising a semiconductor doped with an n-type impurity, and an i-layer comprising mainly microcrystalline silicon-germanium that is provided between the p-layer and the n-layer, wherein
a Raman peak ratio Ic(2)/Ia(2) for a substrate-side impurity-doped layer, which is a layer among the p-layer and the n-layer that is positioned closer to the substrate, is not less than 2, in which the Raman peak ratio Ic(2)/Ia(2) represents a ratio within a Raman spectroscopic measurement spectrum of a peak intensity Ic(2) of a crystalline phase relative to a peak intensity Ia(2) of an amorphous phase.

3. The photovoltaic device according to claim 2, further comprising a buffer layer comprising mainly microcrystalline silicon or microcrystalline silicon-germanium between the substrate-side impurity-doped layer and the i-layer.

4. The photovoltaic device according to either claim 1 or claim 3, wherein a germanium concentration within the buffer layer is lower than a germanium concentration within the i-layer.

5. A process for producing a photovoltaic device comprising formation of a photovoltaic layer on top of a substrate,
the formation of the photovoltaic layer comprising the steps of: forming a p-layer comprising a semiconductor doped with a p-type impurity, an i-layer comprising mainly microcrystalline silicon-germanium, and an n-layer comprising a semiconductor doped with an n-type impurity, either in that sequence or in a reverse sequence,
and further comprising a step of forming a buffer layer comprising mainly microcrystalline silicon or microcrystalline silicon-germanium, the step being performed between the step of forming a substrate-side impurity-doped layer, which is a layer among the p-layer and the n-layer that is positioned closer to the substrate, and the step of forming the i-layer, wherein
a Raman peak ratio Ic(1)/Ia(1) for the buffer layer, which represents a ratio within a Raman spectroscopic measurement spectrum of a peak intensity Ic(1) of a crystalline phase relative to a peak intensity Ia(1) of an amorphous phase, is not less than 0.8.

6. A process for producing a photovoltaic device comprising formation of a photovoltaic layer on top of a substrate,
the formation of the photovoltaic layer comprising the steps of: forming a p-layer comprising a semiconductor doped with a p-type impurity, an i-layer comprising mainly microcrystalline silicon-germanium, and an n-layer comprising a semiconductor doped with an n-type impurity, either in that sequence or in a reverse sequence,
and further comprising a step of forming a buffer layer comprising mainly microcrystalline silicon or microcrystalline silicon-germanium, the step being performed between the step of forming a substrate-side impurity-doped layer, which is a layer among the p-layer and the n-layer that is positioned closer to the substrate, and the step of forming the i-layer, wherein
in the step of forming the buffer layer, conditions that result in a Raman peak ratio Ic(1)/Ia(1) for the buffer layer, which represents a ratio within a Raman spectroscopic measurement spectrum of a peak intensity Ic(1) of a crystalline phase relative to a peak intensity Ia(1) of an amorphous phase, of not less than 0.8 are determined in advance and used as a basis for formation of the buffer layer.

7. A process for producing a photovoltaic device comprising formation of a photovoltaic layer on top of a substrate,
the formation of the photovoltaic layer comprising the steps of: forming a p-layer comprising a semiconductor doped with a p-type impurity, an i-layer comprising mainly microcrystalline silicon-germanium, and an n-layer comprising a semiconductor doped with an n-type impurity, either in that sequence or in a reverse sequence, wherein
in the step of forming a substrate-side impurity-doped layer, which is a layer among the p-layer and the n-layer that is positioned closer to the substrate, a Raman peak ratio Ic(2)/Ia(2) of the substrate-side impurity-doped layer, which represents a ratio within a Raman spectroscopic measurement spectrum of a peak intensity Ic(2) of a crystalline phase relative to a peak intensity Ia(2) of an amorphous phase, is not less than 2.

8. A process for producing a photovoltaic device comprising formation of a photovoltaic layer on top of a substrate,
the formation of the photovoltaic layer comprising the steps of: forming a p-layer comprising a semiconductor doped with a p-type impurity, an i-layer comprising mainly microcrystalline silicon-germanium, and an n-layer comprising a semiconductor doped with an n-type impurity, either in that sequence or in a reverse sequence, wherein
in the step of forming a substrate-side impurity-doped layer, which is a layer among the p-layer and the n-layer that is positioned closer to the substrate, conditions that result in a Raman peak ratio Ic(2)/Ic(2) for the substrate-side impurity-doped layer, which represents a ratio within a Raman spectroscopic measurement spectrum of a peak intensity Ic(2) of a crystalline phase relative to a peak intensity Ia(2) of an amorphous phase, of not less than 2 are determined in advance and used as a basis for formation of the substrate-side impurity-doped layer.

9. The process for producing a photovoltaic device according to either claim 7 or claim 8, further comprising a step of forming a buffer layer comprising mainly microcrystalline silicon or microcrystalline silicon-germanium, between the step of forming the substrate-side impurity-doped layer and the step of forming the i-layer.

10. The process for producing a photovoltaic device according to any one of claim 5, claim 6 or claim 9, wherein a germanium concentration within the buffer layer is lower than a germanium concentration within the i-layer.
